(19) Europäisches Patentamt
European Patent Office
Office européen des brevets

(11) **EP 2 759 401 A1**

(12) **EUROPEAN PATENT APPLICATION**

(43) Date of publication:
**30.07.2014 Bulletin 2014/31**

(51) Int Cl.:
**B32B 17/10** (2006.01)   **H01L 31/048** (2014.01)

(21) Application number: **13199883.3**

(22) Date of filing: **31.12.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **24.01.2013 KR 20130008206**

(71) Applicant: **Samsung SDI Co., Ltd.**
**Yongin-si, Gyeonggi-do (KR)**

(72) Inventors:
• **Yang, Jung-Yup**
**Gyeonggi-do (KR)**

• **Ahn, Young-Kyoung**
**Gyeonggi-do (KR)**
• **Park, Bong-Kyoung**
**Gyeonggi-do (KR)**
• **Lebedev, Yury**
**Gyeonggi-do (KR)**

(74) Representative: **Mounteney, Simon James**
**Marks & Clerk LLP**
**90 Long Acre**
**London**
**WC2E 9RA (GB)**

(54) **Thin film solar cell and method of manufacturing the same**

(57)    A thin film solar cell includes a first substrate, a first electrode on the first substrate, and divided by a first dividing groove, a light absorbing layer disposed on the first electrode, and divided by a second dividing groove parallel with the first dividing groove, a second electrode disposed on the light absorbing layer, divided by a third dividing groove that parallel with the first and second dividing grooves, a second substrate disposed on the second electrode, facing the first substrate, and a metal foil attached to the first substrate and the second substrate to encapsulate a gap between the first substrate and the second substrate, a first end portion of the metal foil being attached to a first surface of the first substrate using a metal material, and a second end portion of the metal foil being attached to the second substrate.

FIG. 2

# Description

## BACKGROUND

### 1. Field

The present invention relates to a thin film solar cell and a method of manufacturing the same.

### 2. Description of the Related Art

Traditional energy sources such as gas or coal are closer to becoming exhausted, and there is increasing interest in alternative energy to substitute the traditional energy sources. Solar cells have been highlighted for a next-generation power source. Solar cells may convert solar energy into direct electric energy using a semiconductor device.

## SUMMARY

The present invention provides a thin film solar cell according to claim 1, and a method of manufacturing a thin film solar cell according to claim 11.

Embodiments are directed to a thin film solar cell, including a first substrate, a first electrode disposed on a first surface of the first substrate, and divided by a first dividing groove, a light absorbing layer disposed on the first electrode, and divided by a second dividing groove that is in parallel with the first dividing groove, a second electrode disposed on the light absorbing layer, divided by a third dividing groove that is in parallel with the first and second dividing grooves, and having transmittance, a second substrate disposed on the second electrode, and facing the first substrate, and a metal foil attached to the first substrate and the second substrate so as to encapsulate a gap between the first substrate and the second substrate, a first end portion of the metal foil being attached to a first surface of the first substrate using a metal material arranged on a same plane as the first electrode, and a second end portion of the metal foil being attached to the second substrate.

The metal material may include a same metal as the first electrode.

The metal material and the first electrode may include molybdenum.

The metal material may be arranged along a perimeter of the first substrate.

The first electrode may be surrounded by the metal material and may be separated from the metal material.

The second end portion of the metal foil may be attached to the second substrate using a metal adhesive.

The second end portion of the metal foil may be attached to a first surface of the second substrate facing the first substrate or may be attached to a second surface of the second substrate that is an opposite surface of the first surface of the second substrate.

The thin film solar cell may further include a waterproof member positioned between the first substrate and the second substrate so as to surround the metal foil.

The thin film solar cell may further include a sealing layer interposed between the first substrate and the second substrate.

Each of the first substrate and the second substrate may include a first side, a second side, and a corner part formed where the first side and the second side meet, and the metal foil may include a first sub-metal foil disposed along the first side so as to encapsulate the gap between the first substrate and the second substrate, and a second sub-metal foil disposed along the second side so as to encapsulate the gap between the first substrate and the second substrate.

The first sub-metal foil and the second sub-metal foil may overlap with each other at a position that corresponds to the corner part, and an overlapping region of the first and second sub-metal foils may be integrated using a metal adhesive or welding.

Embodiments are also directed to a thin film solar cell, including a first substrate, a photoelectric conversion unit including a first conductive layer disposed on a first surface of the first substrate, a light absorbing layer disposed on the first conductive layer, and a second conductive layer disposed on the light absorbing layer and having transmittance, the first conductive layer including a first region formed as a first electrode of the photoelectric conversion unit, and a second region spaced apart from the first region, a second substrate facing the first substrate with the photoelectric conversion unit interposed therebetween, and a metal foil attached to the first substrate and the second substrate so as to encapsulate a gap between the first substrate and the second substrate, a first end portion of the metal foil being attached to the first substrate using the second region, and a second end portion of the metal foil being attached to the second substrate.

The first region may be disposed in an inner region of the first conductive layer, and the second region may be disposed in an outer region of the first conductive layer so as to surround the first region.

The first conductive layer may include molybdenum.

Embodiments are also directed to a method of manufacturing a thin film solar cell, the method including disposing a photoelectric conversion unit on a first substrate, wherein the photoelectric conversion unit includes a first conductive layer, a light absorbing layer on the first conductive layer, and a second conductive layer on the light absorbing layer and having transmittance, disposing a second substrate to face the first substrate, and attaching a metal foil to the first substrate and the second substrate so as to encapsulate a gap between the first substrate and the second substrate.

The first conductive layer formed on the first substrate may include a first region and a second region that is spaced apart from the first region, and the attaching of the metal foil may include attaching a first end portion of the metal foil to the first substrate using the second region as a medium.

The first region may be disposed in an inner region of the first conductive layer, and the second region may be disposed in an outer region of the first conductive layer so as to surround the first region.

The disposing of the second substrate may include preparing a second substrate of which first surface is coated with a metal adhesive, the first surface facing the first substrate.

The method may further include disposing a sealing layer to cover the photoelectric conversion unit.

Each of the first substrate and the second substrate may have a quadrangular shape including a first side, a second side, and a corner part formed where the first side and the second side meet, and the attaching of the metal foil may include attaching a first sub-metal foil to the first substrate and the second substrate along the first side so as to encapsulate the gap between the first substrate and the second substrate, and attaching a second sub-metal foil to the first substrate and the second substrate along the second side so as to encapsulate the gap between the first substrate and the second substrate.

The method may further include integrating an overlapping region of the first and second sub-metal foils that overlap with each other at a position that corresponds to the corner part.

The integrating of the overlapping region may include applying a metal adhesive to a gap between the first sub-metal foil and the second sub-metal foil.

The integrating of the overlapping region may include integrating the overlapping region by welding the first sub-metal foil and the second sub-metal foil.

The method may further include forming a waterproof member positioned between the first substrate and the second substrate so as to externally surround the metal foil.

BRIEF DESCRIPTION OF THE DRAWINGS

Features will become apparent to those of skill in the art by describing in detail exemplary embodiments with reference to the attached drawings in which:

FIG. 1 illustrates a top view of a thin film solar cell according to an example embodiment;
FIG. 2 illustrates a cross-sectional view of the thin film solar cell, taken along a line II-II of FIG. 1;
FIG. 3 illustrates a cross-sectional view of a part of a photoelectric conversion unit of FIGS. 1 and 2;
FIG. 4 illustrates an exploded perspective view of an IV portion of FIG. 1;
FIGS. 5A through 5F illustrate cross-sectional views of stages in a method of manufacturing the thin film solar cell of FIG. 2 according to an example embodiment;
FIGS. 6 and 7 illustrate cross-sectional views of thin film solar cells, according to other example embodiments; and
FIG. 8 illustrates a graph showing a test result of a peel strength, according to an example embodiment.

DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art. In the drawing figures, the dimensions of layers and regions may be exaggerated for clarity of illustration. Like reference numerals refer to like elements throughout.

Terms such as "comprise" or "comprising" are used to specify existence of a recited form, a number, a process, an operations, a component, and/or groups thereof, not excluding the existence of one or more other recited forms, one or more other numbers, one or more other processes, one or more other operations, one or more other components and/or groups thereof. While terms "first" and "second" are used to describe various components, the components are not limited to the terms "first" and "second." The terms "first" and "second" are used only to distinguish between each component. It will also be understood that when a layer is referred to as being "on" another layer or substrate, it can be directly on the other layer or substrate, or intervening layers may also be present. In contrast, when an element is referred to as being "directly on" another element or layer, there are no intervening elements or layers present.

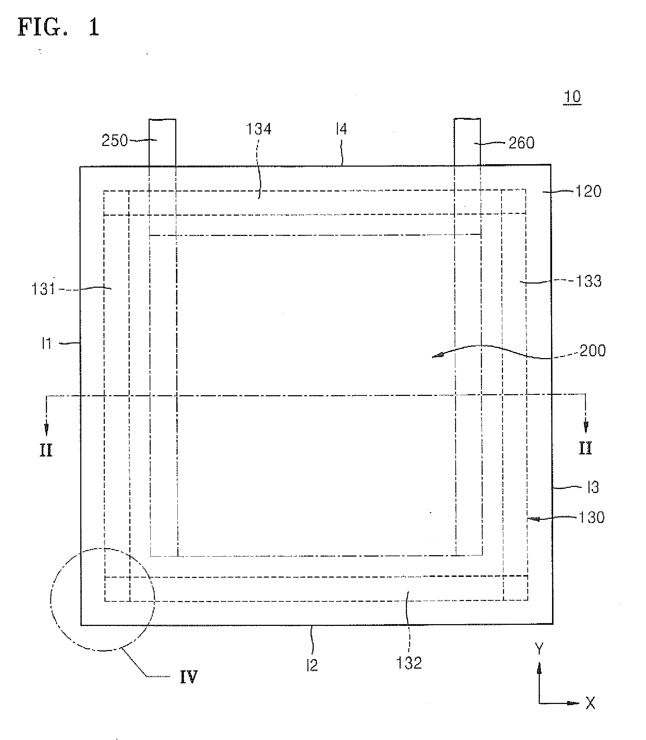

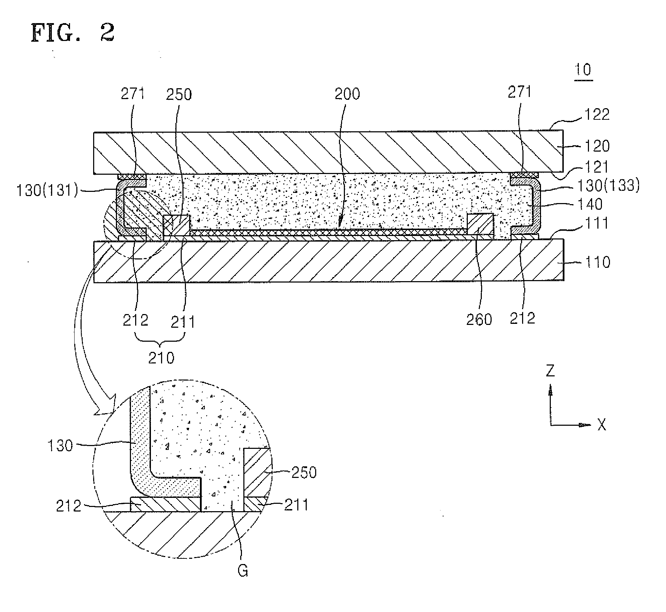

FIG. 1 illustrates a top view of a thin film solar cell according to an example embodiment. FIG. 2 illustrates a cross-sectional view of the thin film solar cell, taken along a line II-II of FIG. 1.

Referring to the example embodiment shown in FIGS. 1 and 2, the thin film solar cell 10 includes a first substrate 110, a second substrate 120, a photoelectric conversion unit 200 formed on a first surface 111 of the first substrate 110, and a metal foil 130 attached to the first substrate 110 and the second substrate 120 and encapsulating a gap between the first substrate 110 and the second substrate 120.

Each of the first substrate 110 and the second substrate 120 has a quadrangular shape having four sides, i.e., first, second, third, and fourth sides $l_1$, $l_2$, $l_3$, and 14, and the first substrate 110 and the second substrate 120 face each other.

The first substrate 110 may be formed of a glass substrate, a polymer substrate, or the like. For example, the glass substrate may be formed of, but not limited thereto, sodalime glass or high strain point sodalime glass, and the polymer substrate may be formed of, but not limited thereto, polyimide.

The second substrate 120 has transmittance, i.e., is formed of a material, e.g., glass, capable of transmitting solar light. For example, the second substrate 120 may be formed of tempered glass, which may help protect the photoelectric conversion unit 200 against an external shock. Also, the second substrate 120 may be formed of low-iron tempered glass containing less iron, which may help prevent reflection of the solar light and increase transmittance with respect to the solar light.

The photoelectric conversion unit 200 is a device that converts solar energy into direct electric energy via a photoelectric conversion effect, and may be a photoelectric conversion unit of a $CuInGaSe_2$ (CIGS) thin film solar cell, an amorphous silicon thin film solar cell, a Cadmium Telluride (CdTe) thin film solar cell, or the like. For convenience, details are provided assuming that the photoelectric conversion unit 200 is a photoelectric conversion unit of the CIGS thin film solar cell, but the photoelectric conversion unit 200 may be a photoelectric conversion unit of the CIS thin film solar cell, the CdTe thin film solar cell, etc.

The metal foil 130 is a quasi-frame that encapsulates the gap between the first substrate 110 and the second substrate 120 so as to block moisture or oxygen that may damage or deteriorate the photoelectric conversion unit 200. The metal foil 130 include metals or alloys thereof such as nickel (Ni), molybdenum (Mo), copper (Cu), silver (Ag), titanium (Ti), tantalum (Ta), aluminum (Al), a tin-lead (Sn-Pb) alloy, etc. In an implementation, the metal foil 130 is formed of stainless steel (SUS). The metal foil 130 be disposed along the four sides $l_1$, $l_2$, $l_3$, and $l_4$ of the first and second substrates 110 and 120 between the first substrate 110 and the second substrate 120.

The metal foil 130 includes a first sub-metal foil 131 extending along the first sides $l_1$ of the first and second substrates 110 and 120, a second sub-metal foil 132 extending along the second sides $l_2$, a third sub-metal foil 133 extending along the third sides $l_3$, and a fourth sub-metal foil 134 extending along the fourth sides $l_4$. The first through fourth sub-metal foils 131 through 134 surround an entire portion of the photoelectric conversion unit 200.

A first end portion of the metal foil 130 is attached to the first substrate 110, and a second end portion of the metal foil 130 attached to the second substrate 120. The first end portion of the metal foil 130 is attached to the first substrate 110 using a metal material 212 arranged on the first surface 111 of the first substrate 110, and the second end portion of the metal foil 130 is attached to the second substrate 120 using an adhesive 271 such as a resin-based adhesive or a metal paste arranged on a first surface 121 of the second substrate 120.

The metal material 212 serves as an adhesion medium between the first substrate 110 and the metal foil 130, and is a part of a first conductive layer 210 of the photoelectric conversion unit 200 which is described below, and includes the same material as a first electrode 211. The first end portion of the metal foil 130 is welded or soldered to the metal material 212 that is a second region of the first conductive layer 210, so that the metal foil 130 is attached to the first substrate 110. In an implementation, ultrasonic welding may be used as the welding.

The welding or the soldering between metal materials (e.g., the second region 212 of the first conductive layer 210) formed on the metal foil 130 and the first substrate 110 may involve welding or soldering metals. Thus, an operation thereof may be easy and it is possible to increase an adhesion strength therebetween.

The adhesive 271 may serve as the adhesion medium between the metal foil 130 and the second substrate 120, and may be formed of, e.g., an acrylate-based material, an epoxy-based material, a urethane-based material, etc. In an implementation, a metal paste including one or more of Ni, Mo, Cu, Ag, Ti, Ta, Al, Sn, Pb, and a metal particle is used in consideration of an adhesion strength and moisture transmission resistivity with respect to the metal foil 130.

A sealing layer 140 is disposed to correspond to the photoelectric conversion unit 200 between the first substrate 110 and the second substrate 120. The sealing layer 140 blocks moisture or oxygen which may have a bad influence upon the metal foil 130 and the photoelectric conversion unit 200. The sealing layer 140 may formed of, e.g., ethylene-vinyl acetate copolymer (EVA), polyvinyl butyral (PVB) ethylenevinylacetic oxide moiety, silicone resin, ester-based resin, or/and olefin-based resin, etc.

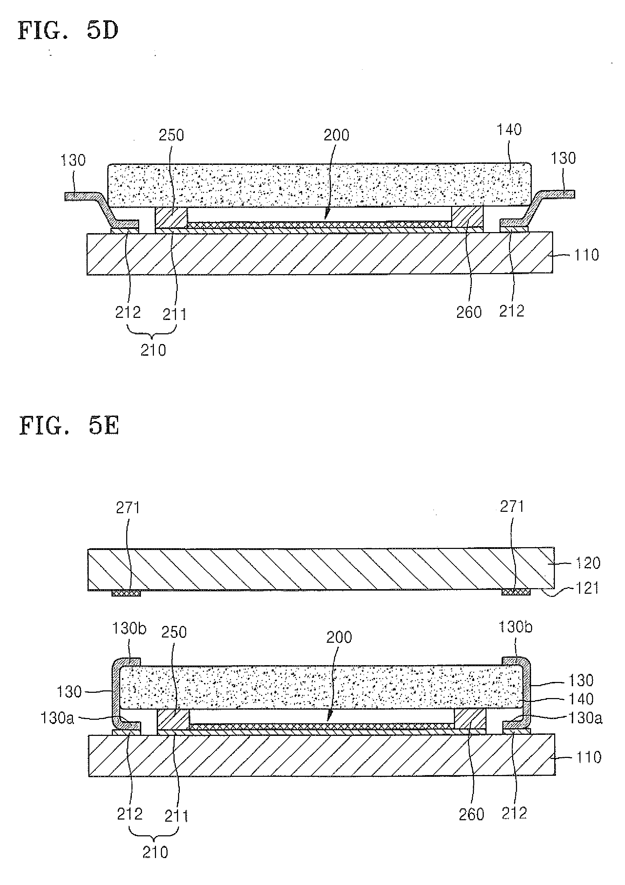

The sealing layer 140 functions to improve workability when the metal foil 130 is attached to the second substrate 120. For example, when the metal foil 130 is attached on the first surface 111 of the first substrate 110 and the first surface 121 of the second substrate 120, the second substrate 120 are positioned while the second end portion of the metal foil 130 is arranged on the sealing layer 140. For example, the sealing layer 140 may support the metal foil 130 and the second substrate 120 so that the metal foil 130 may be easily attached to the second substrate 120 without damaging the metal foil 130. An attachment procedure of the metal foil 130 will be described below with reference to FIGS. 5E through 5F.

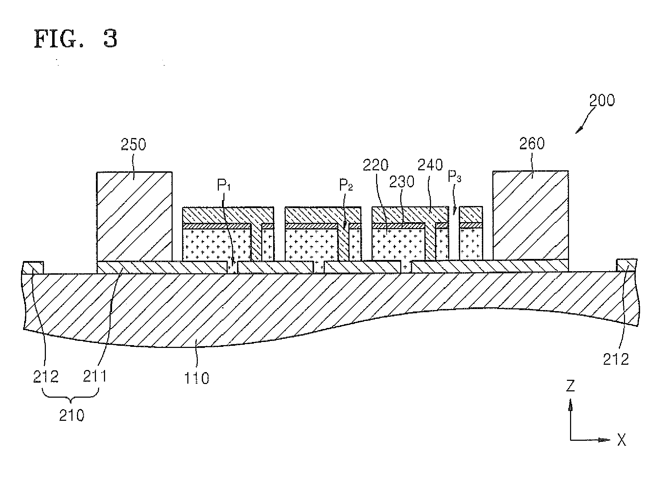

FIG. 3 is a cross-sectional view illustrating a part of the photoelectric conversion unit 200 of FIGS. 1 and 2.

Referring to FIG. 3, the photoelectric conversion unit 200 includes the first conductive layer 210, a light absorbing layer 220 arranged on the first conductive layer 210, and a second conductive layer 240 arranged on the light absorbing layer 220. A buffer layer 230 is interposed between the light absorbing layer 220 and the second conductive layer 240.

The first conductive layer 210 includes a first region 211 and a second region 212 that surrounds the first region 211 by having a distance therebetween. The first region 211 and the second region 212 are separated from each other, e.g., via a scribing process.

The first region 211 functions as the first electrode of the photoelectric conversion unit 200, and the second region 212 functions as the adhesion medium for adhesion of the metal foil 130. The second region 212 is separated from the first region 211 such that the second region 212 is electrically separated from the first region 211.

The first region 211 of the first conductive layer 210 collects charge generated by a photoelectric conversion effect. Also, in order to reflect light that passes through the light absorbing layer 220 so as to allow the light absorbing layer 220 to re-absorb the light, the first region 211 may be formed of a metal material such as Mo, Al, or Cu having excellent conductivity and light reflectance. In consideration of high conductivity as the first electrode, an ohmic contact with the light absorbing layer 220, and a high-temperature stability in a selenium (Se) environment, the first region 211 may include Mo. The first region 211 may be formed as a multi-layer so as to achieve adhesion with the first substrate 110 and a self-resistance characteristic as the first electrode.

The first region 211 is divided by a first dividing groove P1. The first dividing groove P1 is in parallel with the first sides $l_1$ of the first substrate 110.

The light absorbing layer 220 may be formed as, e.g., a p-type semiconductor layer formed of a Cu(In, Ga)Se$_2$ (CIGS)-based compound including Cu, indium (In), gallium (Ga), and Se, and absorbs incident solar light. The light absorbing layer 220 is formed in the first dividing groove P1.

The buffer layer 230 reduces a band gap difference between the light absorbing layer 220 and the second conductive layer 240 (described below), and reduces recombination of electrons and holes, which may occur at an interface between the light absorbing layer 220 and the second conductive layer 240. The buffer layer 230 may be formed of, e.g., CdS, ZnS, In$_2$S$_3$, or Zn$_x$Mg$_{(1-x)}$O.

Each of the light absorbing layer 220 and the buffer layer 230 are divided by a second dividing groove P2. The second dividing groove P2 is at a position spaced apart from the first dividing groove P1 and is in parallel with the first dividing groove P1. The second dividing groove P2 exposes the first conductive layer 210, e.g., a top surface of the first region 211 of the first conductive layer 210.

The second conductive layer 240 forms a P-N junction with the light absorbing layer 220 and functions as a second electrode of the light absorbing layer 220. The second conductive layer 240 is a light-transmitting electrode including a conductive material such as ZnO:B, ITO, or IZO, which transmits light. Thus, the second conductive layer 240 transmits incident light and simultaneously collects charge formed due to the photoelectric conversion effect.

The second conductive layer 240 is formed in the second dividing groove P2 and contacts a lower electrode layer that is exposed due to the second dividing groove P2, so that the second conductive layer 240 electrically connects the light absorbing layers 220 that are divided due to the second dividing groove P2. The second conductive layer 240 is divided by a third dividing groove P3 that is formed at a position spaced apart from the first dividing groove P1 and the second dividing groove P2. The third dividing groove P3 is in parallel with the first dividing groove P1 and the second dividing groove P2, and extends to the first region 211 of the first conductive layer 210 which is the first electrode of the photoelectric conversion unit 200, so that the third dividing groove P3 defines a plurality of photoelectric conversion cells.

An insulating material such as the sealing layer 140 (described below) is filled in the third dividing groove P3. The photoelectric conversion cells are connected in series along a horizontal direction (i.e., an X-axis direction) of FIG. 3.

A first busbar 250 and a second busbar 260 are formed at both sides of the first region 211 (i.e., the first electrode) of the first conductive layer 210, respectively, and function to externally output electricity that is generated in the photoelectric conversion unit 200. The first and second busbars 250 and 260 are formed of a metal material such as a wire, and are electrically connected to the first region 211 of the first conductive layer 210 by performing soldering, ultrasonic welding, adhesion using a paste, or adhesion using a conductive tape.

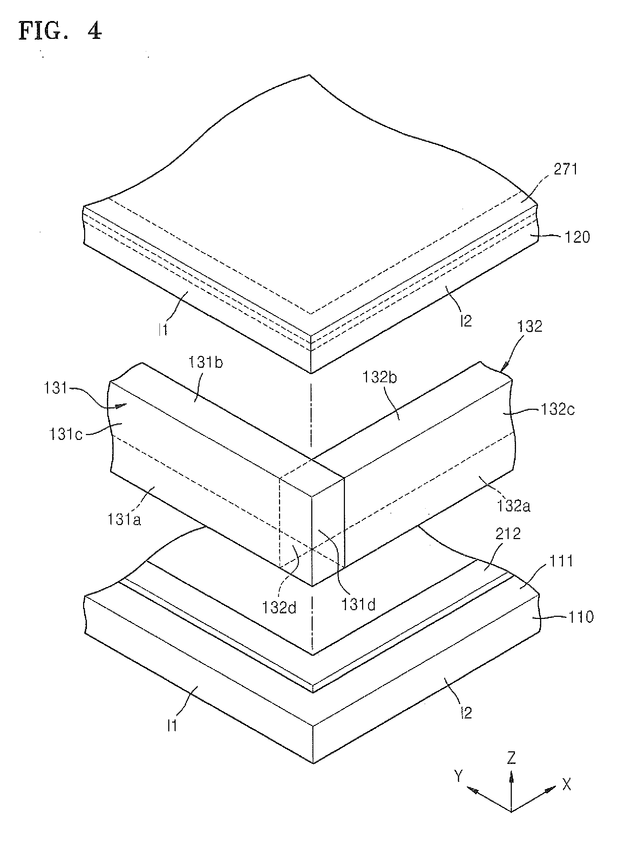

Hereinafter, the metal foil 130 attached to the first and second substrates 110 and 120 at positions that correspond to corner parts of the first and second substrates 110 and 120, respectively, will now be described with reference to FIG. 4.

FIG. 4 is an exploded perspective view of an IV portion of FIG. 1. Referring to FIG. 4, each of the first substrate 110 and the second substrate 120 includes the corner part formed of the first side 11 and the second side 12 that meet each other.

The first sub-metal foil 131 extends lengthwise along the first side 11, a first end portion 131a of the first sub-metal foil 131 is attached to the first substrate 110 using the metal material formed on the first substrate 110, which is the second region 212 of the first conductive layer 210, as a medium, and a second end portion 131b of the first sub-metal foil 131 is attached to the second substrate 120 using the adhesive 271 such as a metal paste formed on the second substrate 120. To do so, the first and second end portions 131a and 131b of the first sub-metal foil 131 are bent with respect to a main surface 131c.

The second sub-metal foil 132 extends lengthwise along the second side 12, a first end portion 132a of the second sub-metal foil 132 is attached to the first substrate 110 using the metal material formed on the first substrate 110, which is the second region 212 of the first conductive layer 210, as a medium, and a second end portion 132b of the second sub-metal foil 132 is attached to the second substrate 120 using the adhesive 271 such as a metal paste formed on the second substrate 120. To do so, the first and second end portions 132a and 132b of the second sub-metal foil 132 are bent with respect to a main surface 132c.

If a fine crack occurs at the corner part where the first sub-metal foil 131 and the second sub-metal foil 132 meet each other, it may be difficult to protect the photoelectric conversion unit 200 against moisture or oxygen. In order to prevent the occurrence of these problems, according to the present embodiment, the first sub-metal foil 131 and the second sub-metal foil 132 partly overlap with each other, and then the overlapping regions are integrally connected using an adhesive such as a metal paste or by performing welding, so that the occurrence of the fine crack may be prevented.

The overlapping regions of the first sub-metal foil 131 and the second sub-metal foil 132 are formed at positions that correspond to the corner parts. For example, the first end portion 131 a of the first sub-metal foil 131 and the first end portion 132a of the second sub-metal foil 132 may overlap at the position corresponding to the corner part, and the second end portion 131b of the first sub-metal foil 131 and the second end portion 132b of the second sub-metal foil 132 may overlap at the position corresponding to the corner part. Also, an end portion 131d of the main surface 131c of the first sub-metal foil 131 may be bent so as to partly overlap with the main surface 132c of the second sub-metal foil 132, and an end portion 132d of the main surface 132c of the second sub-metal foil 132 may be bent so as to partly overlap with the main surface 131 c of the first sub-metal foil 131.

In the above, the first and second sub-metal foils 131 and 132 at the positions that correspond to the corner parts formed of the first and second sides 11 and 12 are described with reference to FIG. 4. In this regard, sub-metal foils (e.g., the sub-metal foils 132 and 133, the sub-metal foils 133 and 134, and the sub-metal foils 134 and 132) at positions that correspond to other corner parts also have the same structure.

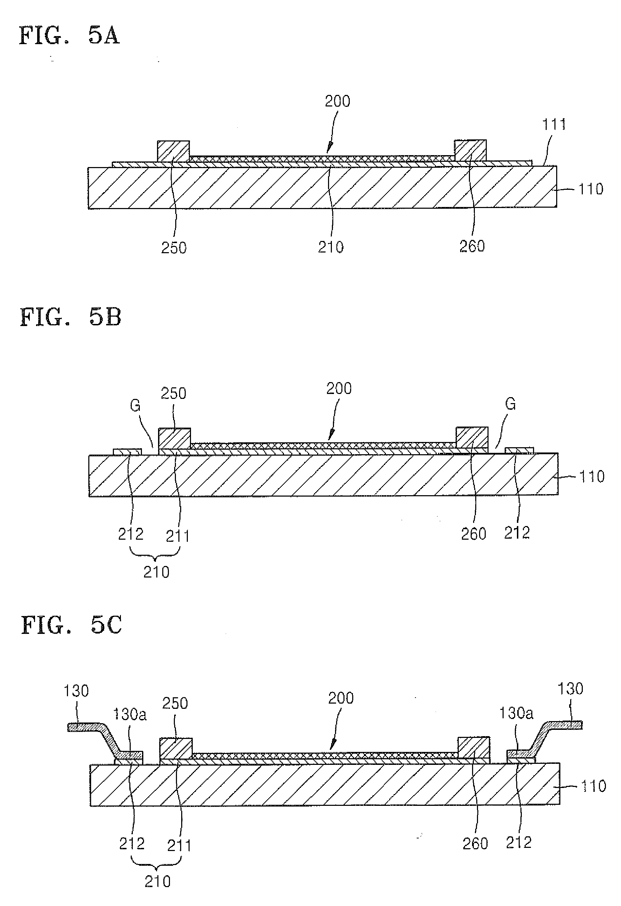

Hereinafter, a method of manufacturing the thin film solar cell 10 of FIG. 2 will now be described with reference to FIGS. 5A through 5F. FIGS. 5A through 5F are cross-sectional views illustrating statuses of the thin film solar cell 10 of FIG. 2 according to manufacturing processes, according to an example embodiment.

Referring to FIG. 5A, the first conductive layer 210 is formed on the first surface 111 of the first substrate 110, and then the photoelectric conversion unit 200 that uses the first conductive layer 210 as a first electrode is formed.

The first conductive layer 210 may be formed via a sputtering process using a molybdenum target. In another implementation, the first conductive layer 210 may be formed by coating a conductive paste on the first surface 111 of the first substrate 110 and then performing thermal treatment on the conductive paste or may be formed using a plating process or the like. The first conductive layer 210 may include a metal material such as Al, Cu, or the like, other than Mo.

The photoelectric conversion unit 200 is formed to have a structure described above with reference to FIG. 2. The photoelectric conversion unit 200 is manufactured according to processes to be described below.

After the first conductive layer 210 is formed, as illustrated in FIG. 2, the first dividing groove P1 is formed via a scribing process, so that the first region 211 of the first conductive layer 210 is divided, and then, after the light absorbing layer 220 and the buffer layer 230 are formed, the second dividing groove P2 is formed via a scribing process. The light absorbing layer 220 and the buffer layer 230 may be formed using various methods.

After the second conductive layer 240 is formed, the third dividing groove P3 is formed via a scribing process. The second conductive layer 240 is formed of a transparent conductive material such as ZnO:B, ITO, or IZO, by performing metalorganic chemical vapor deposition (MOCVD), low pressure chemical vapor deposition (LPCVD), a sputtering method, etc.

Next, the first busbar 250 and the second busbar 260 are formed at sides of the photoelectric conversion unit 200. The first busbar 250 and the second busbar 260 are formed of a metal material such as a wire, and may be electrically connected to the first conductive layer 210 by performing soldering, ultrasonic welding, adhesion using a paste, or adhesion using a conductive tape.

After the aforementioned processes, the photoelectric conversion unit 200 in which photoelectric conversion cells are connected in series is formed. In an implementation, a width of the first conductive layer 210 is greater than a width of the photoelectric conversion unit 200.

Referring to FIG. 5B, the first conductive layer 210 formed on the first substrate 110 is divided into the first region 211 and the second region 212.

A groove G is formed via a scribing process. Thus, the first conductive layer 210 is divided into the first region 211 that is arranged in a center region, and the second region 212 that is formed along a perimeter of the first region 211 by having a distance therebetween. Thus, the second region 212 has a frame shape that is separated from the first region 211 and that surrounds the first region 211. The scribing process may include, e.g., a laser scribing process or a mechanical scribing process.

As described above, the first region 211 functions as the first electrode of the photoelectric conversion unit 200, and the second region 212 is used as the adhesion medium for adhesion of the metal foil 130. The first region 211 and the second region 212 are separated from the first conductive layer 210 via the aforementioned processes. Thus, the first region 211 and the second region 212 include the same metal material.

Referring to FIG. 5C, the metal foil 130 is attached to the first substrate 110. For example, a first end portion 130a of a metal thin plate is disposed on the second region 212 and then is laser-welded or ultrasonic-welded, so that the metal foil 130 is attached to the first substrate 110. The second region 212 includes the metal material. Thus, welding between the second region 212 and the metal foil 130 may be performed between metal materials, so that a performance of the welding is excellent and an adhesion strength therebetween may be increased.

In the present example embodiment, the metal foil 130 and the second region 212 are welded so that the metal foil 130 is attached to the first substrate 110. In another embodiment, the first end portion 130a of the metal foil 130 is attached to the second region 212 via, e.g., soldering, etc.

Referring to FIG. 5D, the sealing layer 140 is arranged on the photoelectric conversion unit 200. The sealing layer 140 is formed of, e.g., ethylene vinyl acetate copolymer resin (EVA), polyvinyl butyral(PVB), ethylenevinylacetate oxide moiety, silicone resin, ester-based resin, olefin-based resin, or the like. The sealing layer 140 has a size greater than a size of the photoelectric conversion unit 200 so as to cover the photoelectric conversion unit 200 and the first end portion 130a of the metal foil 130 which is attached to the second region 212. A second end portion 130b of the metal foil 130 is bent to be arranged on the sealing layer 140.

Referring to FIG. 5E, the second substrate 120 having the adhesive 271 arranged on a perimeter of the first surface 121 is prepared and then is disposed, so that the first surface 121 faces the first substrate 110.

The adhesive 271 may include an acrylate-based material, an epoxy-based material, and a urethane-based material and is arranged on the second substrate 120 via a printing process such as screen printing. However, in consideration of an adhesion strength with respect to the metal foil 130, the adhesive 271 may be formed as a metal paste. For example, the adhesive 271 may be the metal paste including one or more of Ni, Mo, Cu, Ag, Ti, Ta, Al, Sn, Pb, a metal particle, etc. The metal paste is formed on and along the perimeter of the first surface 121 of the second substrate 120 via a printing process such as screen printing. In an embodiment, when the adhesive 271 has a black color, the adhesive 271 may improve an exterior of a module.

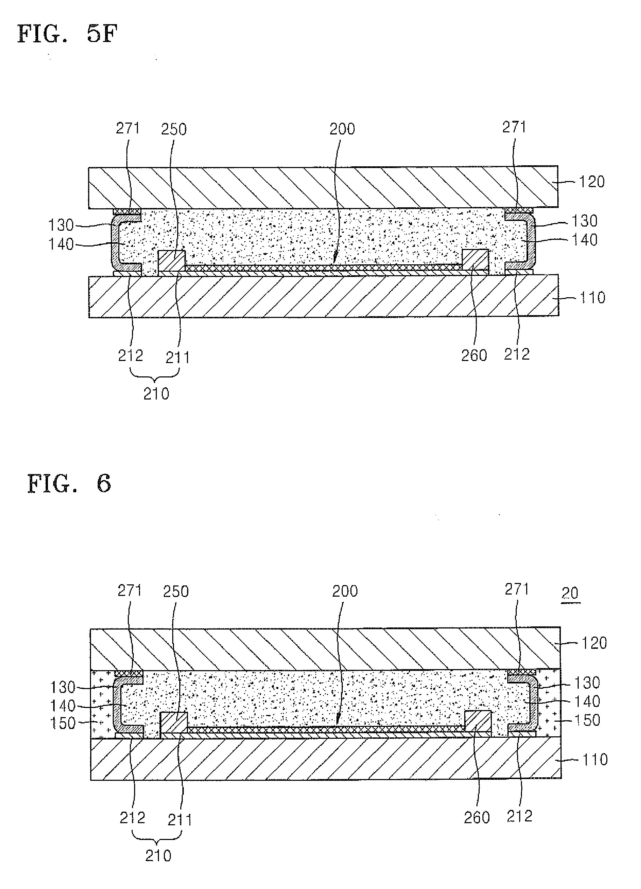

Referring to FIG. 5F, the metal foil 130 is attached to the second substrate 120. For example, the second substrate 120 may be disposed in such a manner that the adhesive 271 is arranged on the second end portion 130b of the metal foil 130, and then a lamination process may be performed to integrally form the first substrate 110 and the second substrate 120.

When heat of a predetermined temperature is applied via the lamination process, the sealing layer 140 is equally filled in a space between the first substrate 110 and the second substrate 120, the adhesive 271 is hardened, and the second end portion 130b of the metal foil 130 is firmly attached to the second substrate 120.

In the present example embodiment, the adhesive 271 is the metal paste. However, in another embodiment, the adhesive 271 is a metal layer formed on the second substrate 120. In this case, adhesion between the second substrate 120 and the adhesive 271 that is the metal layer may be achieved by performing welding.

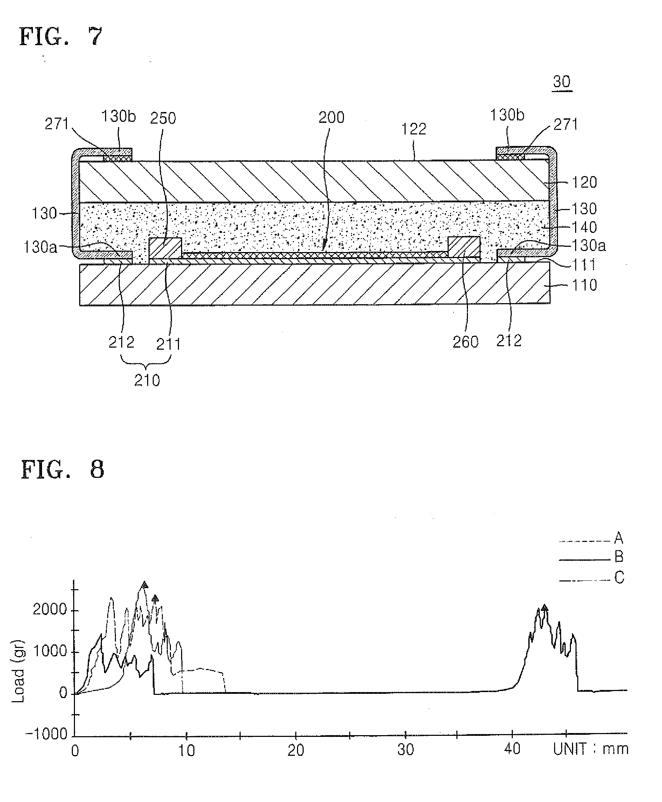

FIGS. 6 and 7 are cross-sectional views of thin film solar cells 20 and 30, according to other example embodiments.

Referring to FIG. 6, the thin film solar cell 20 further includes a waterproof member 150 that is interposed between the first substrate 110 and the second substrate 120 and that is formed along the first substrate 110 and the second substrate 120 so as to surround a metal foil 130. The waterproof member 150 may include, e.g., a silicone-based material or a butyl-based material, and has a waterproof characteristic capable of blocking moisture and may be externally flowed.

Referring to FIG. 7, the thin film solar cell 30 has a structure in which the first end portion 130a of the metal foil 130 is attached to the first surface 111 of the first substrate 110, and the second end portion 130b of the metal foil 130 is attached to the second surface 122 of the second substrate 120.

A path along which moisture (which may have a bad influence upon a photoelectric conversion unit 200) may infiltrate is formed along an interface between different members, i.e., along interfaces between the metal foil 130 and the first and second substrates 110 and 120. The metal foil 130 is adhered to the first and second substrates 110 and 120 using a metal material (i.e., a second region 212 of a first conductive layer 210, and a metal adhesive 271) as a medium, and in this regard, since the metal material has an excellent waterproof characteristic, moisture may hardly permeate. Also, since the second end portion 130b of the metal foil 130 is attached to the second surface 122 of a second substrate 120, a permeation path of moisture is long, so that the photoelectric conversion unit 200 may be further effectively protected.

In order to form the thin film solar cell 30, a thickness of each of the first substrate 110 and the second substrate 120 may be relatively thin. In this case, if the second end portion 130b of the metal foil 130 were attached to a side surface of the second substrate 120, an adherence area between the second end portion 130b and the side surface of the second substrate 120 may not be sufficient, such that the metal foil 130 may be easily peeled. However, in the present example embodiment, when the second end portion 130b is attached to a first surface 121 of the second substrate 120, it is possible to increase an adherence area and simultaneously to form a long moisture permeation path.

Also, as in the previous embodiment, the first end portion 130a of the metal foil 130 are attached to the first substrate 110 using a partial region of the first conductive layer 210, i.e., the second region 212 of the first conductive layer 210. Accordingly, it is possible to save materials and reduce manufacturing costs.

In general, moisture that flows into a thin film solar cell may be calculated using a Water Vapor Transmission Rate (WVTR) and a Q(t) value. The WVTR means a transmission rate of water vapor at a particular temperature and indicates a value that corresponds to transmitted moisture amount/area/time. The Q(t) value indicates a total amount of transmitted moisture. The Q(t) value may be calculated by integrating the WVTR using Equation 1 below.

$$Q(t) = \int_0^t WVTR(t)dt \quad \text{--- Equation 1}$$

In a comparative example, the WVTR of a case in which a photoelectric conversion unit is encapsulated using only an EVA film is about $10 g/m^2/day$, and the WVTR of a case in which a photoelectric conversion unit is encapsulated using a butyl-based waterproof material is about $0.1 g/m^2/day$.

On the other hand, as illustrated in the present embodiment of FIG. 1, when the photoelectric conversion unit 200 is encapsulated using the metal foil 130, the WVTR is about $0.001 g/m^2/day$ which has an effect about 10 through 100 times better than the comparative examples. That is, using the metal foil 130, external moisture is effectively blocked.

Also, according to the one or more embodiments, adherence between the metal foil 130 and the first substrate 110 is achieved using the metal material, so that not only may welding or soldering be easily performed, but also an adhesion strength is improved and moisture transmission resistivity is increased.

FIG. 8 is a graph showing a test result of a peel strength between the second region 212 including Mo and the metal foil 130 including Al, according to an example embodiment. In the present example embodiment, the peel strength test was performed on each of three samples A, B, and C, and the peel strength test was performed after the metal foil 130 including A1 is attached to the second region 212 including Mo via ultrasonic welding.

When a peel strength of the metal foil 130 that is attached on the first substrate 110 using the second region 212 is calculated based on data obtained from the graph of FIG. 8, the peel strength has a value of about 8.82N/mm to 19.6N/mm. That is, a minimum peel strength is about 8.82N/mm, and a maximum peel strength is about 19.6N/mm.

On the other hand, although not illustrated in FIG. 8, in a comparative example with respect to the present embodiment, when a metal foil including A1 is attached to a first substrate using an acrylate-based adhesion medium material, and then a peel strength is calculated, the peel strength is in a range between 2.1N/mm to 4.4N/mm. That is, in the comparative example, a minimum peel strength is about 2.1N/mm, and a maximum peel strength is about 4.4N/mm.

Comparing the comparative example and the present embodiment, the peel strength of the present embodiment in which the metal foil 130 is attached to the second region 212 including Mo is at least four times greater than the peel strength of the comparative example.

The fact that the peel strength is great means that a possibility of external moisture permeation is reduced, so that the great peel strength may be good in terms of reliability with respect to moisture transmission resistivity of the thin film solar cell. Also, it is possible to obtain a result similar to the aforementioned effect, when the metal paste is used as the adhesive 271 to adhere the metal foil 130 and the second substrate 120.

As described above, according to the one or more of the above example embodiments, external moisture is effectively blocked due to a quasi-frame structure using the metal foil.

Also, the metal foil and the substrate can be adhered using the metal material, such that welding or soldering may be easily performed, an adhesion strength is increased, and moisture transmission resistivity is improved.

In addition, since a partial region of the first conductive layer of the photoelectric conversion unit is used as the metal material to be used in adhesion between the metal foil and the first substrate, an efficiency of the manufacturing process may be significantly improved.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

**Claims**

1. A thin film solar cell, comprising:

   a first substrate (110);
   a photoelectric conversion unit (200) including a first conductive layer (210) disposed on a first surface (111) of the first substrate, a light absorbing layer (220) disposed on the first conductive layer, and a second electrode formed as a second conductive layer (240) disposed on the light absorbing layer (220) and having transmittance, the first conductive layer (210) including a first region (211) formed as a first electrode of the photoelectric conversion unit, and a second region (212) spaced apart from the first region; a second substrate (120) facing the first substrate with the photoelectric conversion unit (200) interposed therebetween; and a metal foil (130) attached to the first substrate (110) and the second substrate (120) so as to encapsulate a gap between the first substrate and the second substrate, a first end portion of the metal foil being attached to the first substrate (110) using the second region (212), and a second end portion of the metal foil being attached to the second substrate (120).

2. The thin film solar cell as claimed in claim 1, wherein:

the first electrode (211) of the photoelectric conversion unit (200) is divided by a first dividing groove (P1); the light absorbing layer (220) is divided by a second dividing groove (P2) that is in parallel with the first dividing groove; the second electrode is divided by a third dividing groove (P3) that is in parallel with the first and second dividing grooves, and has transmittance.

3. The thin film solar cell as claimed in claim 1 or 2, wherein the first conductive layer (210) includes molybdenum.

4. The thin film solar cell as claimed in any one of the preceding claims, wherein the first region (211) is disposed in an inner region of the first conductive layer, and the second region (212) is disposed in an outer region of the first conductive layer so as to surround the first region.

5. The thin film solar cell as claimed in any one of the preceding claims, wherein the second end portion of the metal foil (130) is attached to the second substrate (120) using a metal adhesive (271).

6. The thin film solar cell as claimed in any one of the preceding claims, wherein the second end portion of the metal foil (130) is attached to a first surface of the second substrate (120) facing the first substrate or is attached to a second surface of the second substrate that is an opposite surface of the first surface of the second substrate (120).

7. The thin film solar cell as claimed in any one of the preceding claims, further comprising a waterproof member positioned between the first substrate (110) and the second substrate (120) so as to surround the metal foil (130).

8. The thin film solar cell as claimed in any one of the preceding claims, further comprising a sealing layer (140) interposed between the first substrate and the second substrate.

9. The thin film solar cell as claimed in any one of the preceding claims, wherein each of the first substrate (110) and the second substrate (120) includes a first side, a second side, and a corner part formed where the first side and the second side meet, and the metal foil (130) includes:

a first sub-metal foil (131) disposed along the first side so as to encapsulate the gap between the first substrate and the second substrate; and a second sub-metal foil (132) disposed along the second side so as to encapsulate the gap between the first substrate and the second substrate.

10. The thin film solar cell as claimed in claim 9, wherein the first sub-metal foil (131) and the second sub-metal foil (132) overlap with each other at a position that corresponds to the corner part, and an overlapping region of the first and second sub-metal foils is integrated using a metal adhesive or welding.

11. A method of manufacturing a thin film solar cell, the method comprising:

disposing a photoelectric conversion unit (200) on a first substrate (110), wherein the photoelectric conversion unit includes a first conductive layer (210), a light absorbing layer (220) on the first conductive layer (210), and a second conductive layer (240) on the light absorbing layer and having transmittance; disposing a second substrate (120) to face the first substrate; and attaching a metal foil (130) to the first substrate and the second substrate so as to encapsulate a gap between the first substrate and the second substrate.

12. The method as claimed in claim 11, wherein:

the first conductive layer (210) formed on the first substrate includes a first region (211) and a second region (212) that is spaced apart from the first region, and the attaching of the metal foil (130) includes attaching a first end portion of the metal foil to the first substrate using the second region as a medium.

13. The method as claimed in claim 12, wherein the first region (211) is disposed in an inner region of the first conductive layer (210), and the second region (212) is disposed in an outer region of the first conductive layer so as to surround the first region.

14. The method as claimed in claim 11, 12, or 13, wherein the disposing of the second substrate (120) includes coating a first surface of the second substrate with a metal adhesive (271), the first surface facing the first substrate (110).

15. The method as claimed in any one of claims 11 to 14, further comprising disposing a sealing layer (140) to cover the photoelectric conversion unit (200).

16. The method as claimed in any one of claims 11 to 15, wherein each of the first substrate (110) and the second substrate (120) has a quadrangular shape including a first side, a second side, and a corner part formed where the first side and the second side meet, and
the attaching of the metal foil (130) includes:

   attaching a first sub-metal foil (131) to the first substrate and the second substrate along the first side so as to encapsulate the gap between the first substrate and the second substrate; and attaching a second sub-metal foil (132) to the first substrate and the second substrate along the second side so as to encapsulate the gap between the first substrate and the second substrate.

17. The method as claimed in claim 16, further comprising integrating an overlapping region of the first and second sub-metal foils that overlap with each other at a position that corresponds to the corner part.

18. The method as claimed in claim 17, wherein the integrating of the overlapping region includes applying a metal adhesive to a gap between the first sub-metal foil and the second sub-metal foil.

19. The method as claimed in claim 17, wherein the integrating of the overlapping region includes integrating the overlapping region by welding the first sub-metal foil and the second sub-metal foil.

20. The method as claimed in any one of claims 11 to 19, further comprising forming a waterproof member (150) positioned between the first substrate (110) and the second substrate (120) so as to externally surround the metal foil.

FIG. 1

FIG. 2

FIG. 3

# FIG. 4

# FIG. 5A

# FIG. 5B

# FIG. 5C

## FIG. 5D

## FIG. 5E

FIG. 5F

271   250                           200                              271
                                                                              120
130                                                                    130
140                                                                    140

212   211                                                    260   212
      210

FIG. 6

271   250                           200                        271   20
                                                                              120
130                                                                    130
140                                                                    140
150                                                                    150
                                                                              110

212   211                                                    260   212
      210

FIG. 7

FIG. 8

Europäisches
Patentamt

European
Patent Office

Office européen
des brevets

## EUROPEAN SEARCH REPORT

Application Number

EP 13 19 9883

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | US 2010/126581 A1 (NISHI HIROFUMI [JP] ET AL) 27 May 2010 (2010-05-27)<br>* abstract *<br>* paragraphs [0001] - [0002], [0009], [0011] - [0012], [0017] - [0019], [0022] - [0030], [0042] - [0050]; figure 3 *<br>----- | 11,15<br><br>12-14, 16-20 | INV.<br>B32B17/10<br>H01L31/048 |
| X<br>Y | US 2011/011443 A1 (YATA SHIGEO [JP] ET AL) 20 January 2011 (2011-01-20)<br>* abstract *<br>* paragraphs [0006], [0025] - [0035], [0039] - [0042], [0044] - [0049], [0051] - [0068]; figures 2-3 *<br>----- | 1-8<br><br>3,9,10, 12-14,20 | |
| Y | US 6 160 645 A (CHANDROSS EDWIN ARTHUR [US] ET AL) 12 December 2000 (2000-12-12)<br>* abstract; figures 1,2, 4,6 *<br>* column 1, lines 5-6, 54 - column 2, line 4 *<br>* column 3, lines 16-20, 35-47 *<br>* column 4, lines 17-54 *<br>* column 5, lines 25-53 *<br>----- | 9,10, 16-19 | |
| Y | DE 199 50 893 A1 (SAINT GOBAIN [DE]) 3 May 2001 (2001-05-03)<br>* abstract *<br>* column 1, lines 11-22 *<br>* column 2, lines 14-39 *<br>* column 3, line 33 - column 4, line 8 *<br>----- | 3 | |
| A | DE 10 2008 013522 A1 (CELLS AG Q [DE]) 10 September 2009 (2009-09-10)<br>* abstract; figures 2, 3c *<br>* paragraphs [0001] - [0005], [0009], [0012] - [0018], [0020], [0023], [0025] - [0028], [0033] - [0034], [0063], [0068], [0073] *<br>----- | 1,4,7,8, 11-15,20 | |

TECHNICAL FIELDS
SEARCHED (IPC)

H01L
B23B
B32B

The present search report has been drawn up for all claims

| Place of search | Date of completion of the search | Examiner |
|---|---|---|
| Berlin | 31 March 2014 | Cichos, Anna |

EPO FORM 1503 03.82 (P04C01)

**ANNEX TO THE EUROPEAN SEARCH REPORT
ON EUROPEAN PATENT APPLICATION NO.**

EP 13 19 9883

This annex lists the patent family members relating to the patent documents cited in the above-mentioned European search report.
The members are as contained in the European Patent Office EDP file on
The European Patent Office is in no way liable for these particulars which are merely given for the purpose of information.

31-03-2014

| Patent document cited in search report | | Publication date | Patent family member(s) | | Publication date |
|---|---|---|---|---|---|
| US 2010126581 | A1 | 27-05-2010 | DE 112008001045 | T5 | 10-06-2010 |
| | | | JP 4181204 | B1 | 12-11-2008 |
| | | | JP 2008283035 | A | 20-11-2008 |
| | | | TW 200845406 | A | 16-11-2008 |
| | | | US 2010126581 | A1 | 27-05-2010 |
| | | | WO 2008139975 | A1 | 20-11-2008 |
| US 2011011443 | A1 | 20-01-2011 | CN 101958354 | A | 26-01-2011 |
| | | | US 2011011443 | A1 | 20-01-2011 |
| US 6160645 | A | 12-12-2000 | EP 1096340 | A2 | 02-05-2001 |
| | | | JP 3645480 | B2 | 11-05-2005 |
| | | | JP 2001175154 | A | 29-06-2001 |
| | | | KR 20010051237 | A | 25-06-2001 |
| | | | US 6160645 | A | 12-12-2000 |
| DE 19950893 | A1 | 03-05-2001 | DE 19950893 | A1 | 03-05-2001 |
| | | | EP 1094528 | A2 | 25-04-2001 |
| DE 102008013522 | A1 | 10-09-2009 | DE 102008013522 | A1 | 10-09-2009 |
| | | | WO 2009109472 | A1 | 11-09-2009 |

EPO FORM P0459

For more details about this annex : see Official Journal of the European Patent Office, No. 12/82